# EUROPEAN PATENT APPLICATION

(11) **EP 4 450 946 A1**
(43) Date of publication of application: **23.10.2024**
(21) Application number: 23177583.4
(22) Date of filing: 06.06.2023
(51) Int. Cl.: G01M 13/04, G01R 33/06

(54) **DIAGNOSTIC SYSTEM FOR THE DIAGNOSIS OF ROLLING BEARINGS**

(30) Priority: 18.04.2023 PL 44445423
(71) Applicant: Akademia Gorniczo-Hutnicza im. Stanislawa Staszica w Krakowie, 30-059 Krakow (PL)
(72) Inventor: Kwa niewski, Jerzy, 30-211 Kraków (PL); Molski, Szymon, 31-901 Kraków (PL); Roskosz, Maciej, 42-677 Sza sza (PL); Mazurek, Pawe, 30-071 Kraków (PL)
(74) Representative: Balinska, Ewa

(57) **Abstract**

The invention relates to a diagnostic system for diagnosing of rolling bearings during their operation, directly at the place where they are installed in a tested structure, comprising an assembly of sensors arranged in the immediate vicinity of a bearing to be diagnosed and a support element on which the sensors included in the sensor assembly are mounted, which sensors are further connected by means of signal transmission connection to a recording unit in the form of a recorder, which recorder is connected to an analysis block, being characteristic by the sensor assembly that includes at least three sensors which are magneto-impedance sensors (A, B, C; 4, 9) of magnetic field, that are arranged at well-defined locations along a perimeter of the side surface of the diagnosed bearing, wherein at least two sensors (4; A and B) are located at locations lying in the load plane (P) of the bearing, one opposite to each other along a diameter, and wherein at least one sensor (4; C) is located at the side surface of the bearing, in the plane perpendicular to the load plane (P), at a location in angular distance of 90 degrees along the perimeter of the bearing away from the load plane (P), and wherein the support element is equipped with an adjustment system in which magneto-impedance sensors (4, 9; A, B and C) are mounted with possibility of adjustment of their position relative to the diagnosed bearing, in both horizontal and vertical directions.

## Description

The subject of the invention is a diagnostic system for diagnosing of rolling bearings, in particular, allowing assessment of a technical state of bearings during their operation.

### Background

In the art a head for measuring shape deviations in a shape of rings of rolling bearings is known and used for measuring lateral and front surfaces of rolling bearing rings.

Heads that allow measuring shape deviations of rolling bearing surfaces on a measuring stand, usually on a measuring table are also commonly known in the art. They are used in measuring instruments that use a method of measuring a radius change or the reference measurement method. In most cases, during a single measurement of a bearing ring, the geometry of its one surface, such as a bearing raceway (or track) or lateral surface, is evaluated.

Device for measuring bushing roundness outlines is known from Polish patent PL225970B1 for measuring of the inner surfaces of a cylinder bushing. A measuring instrument of this type is constructed of a rotary table, on which the bushing is located, while the measuring head is moving in it. This measuring head in its lower part is connected to a mandrel, fixed longitudinally in supports, seated on a motor-driven carriage. The carriage is mounted slideably in the vertical direction in a linear guide, wherein its position is measured via an angle transducer mounted in the motor. The angle transducer measures an angular position of the table. The presented device only allows measurement of a roundness of inner surface of a bushing, and thus significantly delimits the range of measurement applications of this device.

Another device for measuring circularity of outlines of cylindrical external surfaces is known from Polish patent PL213841B1, that is based on the reference method. This device is constructed with an arm equipped with a slider, on which an inductive sensor is installed and it is connected to an electronic signal recording device mounted directly on the machine tool. The presented device is limited in that it can only measure the shape outlines of outer cylindrical surfaces.

Also known in the art is a shape deviation measuring head that allows simultaneous measurement of a geometry of an outer surface, an inner surface and a face surface of rolling bearing rings. This measuring head can be used in measuring systems for evaluating shape deviations of cylindrical component elements, that systems use the method of measuring radius changes by using a rotating table and/or a sensor. The head comprises an upper guide, in which a holder is slidingly mounted. A measuring sensor is mounted in this holder, while the head also has two side guides in which holders with measuring sensors are also slidingly mounted. This type of the head is used for measuring a surface of an outer ring of a rolling bearing, that is placed on a measuring table of the measuring instrument, wherein sensors are configured for measuring shape deviations of a bearing ring.

Currently, complicated electronic measuring systems that record vibrations over a wide range or bandwidth are mostly used in the art, to detect damage of a bearing during its operation.

Usually, for a given bearing, the range of characteristic frequency (frequencies) of the bearing to be diagnosed is determined, then a diagnostic instrument is applied to the bearing housing, which diagnostic instrument having vibration characteristics that falls within the characteristic frequency range of the bearing to be diagnosed. Next, mechanical and acoustic vibrations that are generated by the diagnostic instrument are monitored, which vibrations are increasing when bearing damage occurs and grows during operation of the bearing. The diagnostic instrument is permanently seated on a bearing housing, wherein it is provided with a housing, inside of which a susceptible, replaceable vibrating element is mounted, having its lower end fixed in a holder, that is mounted in the base of the resonator housing. Upper end of this vibrating element is fixed in a voltage regulator. This type of a diagnostic instrument makes it possible to diagnose the state of a bearing defect without the use of a sensitive apparatus, since there is a strong amplification of the vibrations caused by the bearing defect. The method makes it possible to immediately identify bearing malfunction.

There is also known a method of checking the technical state of a rolling bearing, that is used especially in a process of ongoing inspection of the technical state of rolling elements of a bearing and/or its operating conditions. In these known methods, evaluation of the technical state of the bearing is made by measuring the frequency or the amplitude of a vibration, the temperature or the stress in elements of the bearing node. Measurement of one of these parameters is carried out by means of sensors located in the fixed and/or moving elements of the bearing or elements working with it.

For example, a method of determining the damage of a rolling bearing is known from German patent No. DE2947937, which method consists in measuring the time-varying instantaneous stresses in the contact area of rolling elements with a raceway under normal load and known rotations. Such instantaneous stresses are measured using strain gauges, at least one of which is arranged on a stationary fixed part of the bearing and at least another one is arranged on its moving part.

Disadvantage of the known methods is that the changes of the above-mentioned parameters, that can be recorded occur, usually, when operation of a bearing is significant disturbed, and are accompanied by damage to its rolling elements or a drastic change in operating conditions.

In order to detect malfunctioning of a bearing already at its initial stage, a known method is used, in which the actual number of revolutions of a controlled bearing cage is measured and compared to the theoretical number of revolutions of this cage, determined according to the known relation as a function of the rotation of a moving ring and a diameter of a rolling element and a pitch diameter. The number of revolutions of a cage is measured by measuring the number of pulses of a strain gauge sensor, which number is proportional to the number of the revolutions and to the number of rolling elements. The method according to this solution allows early detection of irregularities in the functioning of a bearing node under operating conditions.

Known from the patent No. CN 115406654 is a method and a device for diagnostics of bearings, in particular for diagnostics of bearings that support a rotating shaft of a drive unit. The device has a magnetic sensor and a vibration sensor, and includes a calculation unit for calculating the period of rotation of a bearing on the basis of the magnetic signal detected by the magnetic sensor, as well as further calculation unit for calculating the natural frequency of the bearing, and a diagnostic unit that evaluates the state of a bearing on the basis of the natural frequency of this bearing. This device has a complex design and is demanding to operate.

The need to provide a simple-to-use and easy-to-apply system for diagnostics of rolling bearings and real-time evaluation of bearing wear state, directly at the bearing site during its operation still exists in the market.

The purpose of the invention is to develop a system for diagnosing of rolling bearings, especially for real-time evaluation of the state of rolling bearings during their operation, and directly at the place where they are installed in an apparatus (a structure) and without any need to disassemble a bearing for performing measurements. The system is designed to detect the state of rolling bearings of different pitch diameters in a wide range of dimensions and sizes and in their state directly installed in the apparatus.

### Essence of the invention

The subject of the invention is a diagnostic system for diagnosing of rolling bearings comprising an assembly of sensors arranged in the immediate vicinity of a housing of the tested bearing at well-defined locations along a perimeter of the bearing, on its lateral surface and directly at the height and along rolling elements, preferably, at a pitch diameter. The sensors included in the sensor assembly are mounted in a support element and they are connected to a recording unit in the form of a recorder, in the way allowing signals transmission, wherein the recorder is connected to an analysis block (analyzer).

The system for diagnosing of rolling bearing according to the invention includes at least three sensors, which are magnetic-impedance sensors of a magnetic field, that are arranged at well-defined locations, wherein at least two sensors are located at defined locations of sensors A and B lying in the load plane P of the bearing, one opposite to each other along a diameter, while at least one sensor C is located on the side surface of the bearing at a location in angular distance of 90 degrees along a circumference of the bearing from the load plane P and in the plane perpendicular to the bearing load plane P. Furthermore, it is essential that all magneto-impedance sensors are located in one, common plane.

In an embodiment of the invention, the sensors are mounted on a support element with possibility of adjusting their position relative to the diagnosed bearing in both horizontal and vertical directions The support element is fixedly attached in a steady manner on a structural element, for example, on a housing or a body of the structure in which the diagnosed bearing is installed, that is a tested structure. Clamping connections, for example, various types of carpenter's clamps or other threaded connections, can be used to fix the attachment.

In an embodiment of the invention, the support element has an adjustment system containing a stationary guiding element, designed to be fixedly mounted on a structural element of the tested structure in which the diagnosed bearing is installed. The guiding element is equipped with crossbars installed on it movably in at least two planes for adjusting the position of the magneto-impedance sensors, that are attached to these crossbars, to the diameter of the bearing.

In preferable embodiment of the invention, sliding elements are mounted slidably in the vertical direction on the guiding element. In the sliding elements crossbars are seated movably in the horizontal direction, on which crossbars individual sensors are mounted, that is at least one sensor or exactly one sensor is mounted on each crossbar.

In another embodiment of the invention, the sensors are arranged and mounted on a flexible for bending segment measuring strip, which is positioned along a periphery of the bearing, along its lateral surface, at the height of the rolling elements and along these rolling elements. The measuring strip is mounted fixedly with respect to the tested bearing on a support element, and in particular on a guiding element of the support element.

In further embodiment of the invention, the segment measuring strip with magneto-impedance sensors mounted to it, along its length is constructed of movably connected segment elements in the form of links and has an overall length L. The segment elements are adjustable and can be adjusted to the diameter of the bearing at the height of its rolling elements, and thus the magnetic field distribution along the rolling elements can be recorded by means of said magneto-impedance sensors. Further wherein, the segment strip is attached to a movable crossbar seated on a guiding element.

In further embodiment of the invention, a signal from each of individual magneto-impedance sensors indicating the distribution of the magnetic field, also referred to as the magnetic signal, is transmitted to a recorder and, further, after the signal is recorded in the recorder, it is transmitted to an analysis block and it is analyzed in this block by comparing the signal signatures from each of the individual magneto-impedance sensors, particularly, of at least from locations A, B and C in which sensors A, B and C are placed.

Advantages of the solution according to the invention consist in that the locations of magneto-impedance sensors A and B in the load plane P of the bearing and at the same time the location of sensor C on the side surface of the bearing, perpendicular to the sensors A and B and with an angular offset of 90 angular degrees from them, are well defined. Further, the location of the measuring strip with sensors are defined on a periphery of the bearing cage at the height of the rolling elements and along them. Thanks to such arrangement of the sensors it is possible to record signals from sensors placed in different locations and to obtain the beneficial effect, that is to obtain information on the state of wear of the bearing, even this wear is small, as a result of accurate analysis of magnetic field distributions acquired during the operation of the bearing.

### Description of figures of the drawing

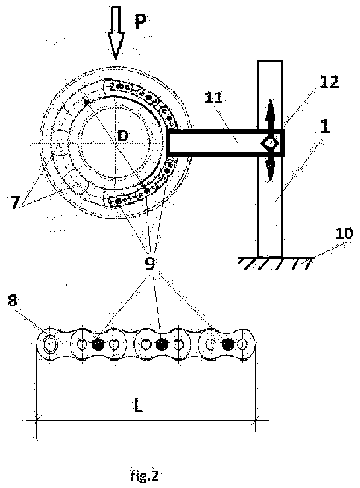

The subject of the invention in embodiments is shown in the drawing, in which fig. 1 shows schematically a diagnostic system for diagnosing of rolling bearing in the first embodiment of the invention, fig. 2 shows in schematic side view the diagnostic system for rolling bearing in the second embodiment of the invention together with the segment measuring strip in top view, fig. 3 shows in schematic side view a support element in the first embodiment of the invention, and fig. 4 shows in schematic top view a support element in the first embodiment of the invention.

### Description of embodiments

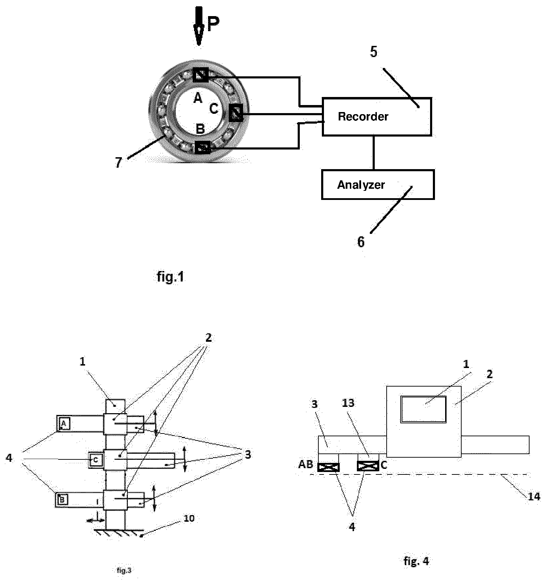

Diagnostic system for diagnosing of rolling bearings in the first embodiment of the invention, shown in figs. 1, 3 and 4, includes an assembly of magnetic field magneto-impedance sensors A, B and C, in the embodiment of the invention comprising at least three magneto-impedance sensors 4, and that sensors 4 allow evaluating the technical state of bearings during their operation at the place where they are installed in the tested structure 10 i.e. a structure to be tested. The magneto-impedance sensors 4, A, B and C are connected, in a signal transmitting manner, to a recording unit 5 in the form of a recorder 5, in a way that allows transmission of signals, especially transmitting the magnetic signal about the magnetic field distribution, and further the recorder 5 is connected to an analysis block 6 in the form of an analyzer 6.

It is essential according to the invention, in both embodiments, to locate all magneto-impedance sensors A, B, C, 4, 9 of the diagnostic system in one common plane in a direct vicinity to the plane of the (tested) bearing 14 movement, that is possible thanks to the use of spacers 13. The exact position of these sensors is fixed by means of a suitable support element with an adjustment system.

According to the invention, in the first embodiment, locations of two magneto-impedance sensors 4, A and B in the load plane P of the bearing, opposite to each other along the diameter of the bearing, and the location of third magneto-impedance sensor 4, C perpendicular to them on the side surface of the bearing, at the location away from the load plane P of the bearing, in a distance of 90 angular degrees along a circumference of the bearing, in the plane perpendicular to the load plane P on the periphery of the bearing, at its side surface and at the height of the rolling elements 7 of the bearing, are defined, and/or in the second embodiment of the invention, the location of the measuring strip 8 with the magneto-impedance sensors 9 attached to it on the periphery of the bearing 14 at the height and along the rolling elements 7 is defined.

The magnetic signal recorded by the magneto-impedance sensors A, B, C, 4 and 9 is transmitted to and recorded in the recorder 5, and after the signal is recorded in the recorder 5, it is analyzed in the analyzer block 6 by the analysis unit 6 by comparing signatures of the signal from the individual sensors 4, A, B, C and 9. Each of the sensors 4, A, B, C and 9 measures the magnetic field generated by the rotating bearing 14. The amplitudes of these measured magnetic field signals change and they vary according to the work done by the bearing and the state of its loading. In the analysis unit 6, the currently recorded signal signatures are compared to their initial state for the new bearing. The change in the recorded amplitude is a measure of the degree of wear of the bearing.

The magneto-impedance sensors 4, A, B and C of the assembly of magnetic field magneto-impedance sensors in the first embodiment according to the invention are mounted on a support element equipped with an adjustment system. The adjustment system includes a stabilized guiding element 1, fixedly mounted on a structural element 10 of the structure that is tested, for example such as a support frame of a drive unit to be under examination, in which structure the diagnosed rolling bearing 14 is fixed. On the support element crossbars 2, 3 are fixed movably in two planes with attached sensors 4, A, B and C to them, which crossbars adjust the position of these sensors 4 to the diameter of the bearing to be diagnosed. The crossbars 3 are fixed movably in the horizontal direction in the slide elements 2, which are installed movably in vertical direction on the guiding element 1. The guiding element 1 is mounted in a stabilized manner on the structural element 10 of the diagnosed bearing that is mounted in the tested structure (fig. 3). On the guiding element are arranged vertically movable slide elements 2, in which, preferably, three crossbars 3 are installed movably in the horizontal direction. Advantageously, measuring magneto-impedance sensors 4, A, B and C are mounted on each crossbar 3, respectively one sensor on each crossbar 3. Thanks to the movable crossbars 3, it is possible to adjust the position of the sensors with respect to the pitch diameter D of the bearing cages. All magneto-impedance sensors 4, A, B, C and 9 are located in a common single plane, as shown in fig. 4, close to the diagnosed bearing 14 in the immediate vicinity of its side surface and its rolling elements by means of spacers 13.

The diagnostic system for rolling bearings in the second embodiment of the invention includes a of a magnetic field magneto-impedance sensors 9 assembly containing a plurality of magneto-impedance sensors 9, preferably, at least three sensors 9, that are attached to a segment measuring strip 8 with sensors 9, which strip is stably mounted on the support element and which strip 8 is constructed of movably connected at their ends, one to each other, segment elements 8 in the form of links 8. The connected segment elements 8 form a strip of overall length L, that can be adjusted to the diameter of the bearing at the height of its rolling elements 7. The arrangement of the magneto-impedance sensors 9 makes it possible to record the magnetic field distribution along the rolling elements 7. When a number of work cycles of the bearing increase, changes of generated magnetic field are caused, which changes can makes possible to evaluate the degree of the wear of the bearing.

On the segment measuring strip 8 consisting of a system of movable links forming interconnected segments 8, which are made of non-magnetic materials, magneto-impedance sensors 9 of magnetic field are arranged and fixed. The length L of the segment strip 8 depends on the pitch diameter D of the bearing cage. The segment measuring strip 8 is mounted to a movable crossbar 11, that is movably mounted on a guiding element 1 of the support element, which movable crossbar can move along said guiding element 1, especially in the horizontal direction. The guiding element 1 is placed as fixed in a stable manner on the structural element 10 of the tested structure, in which the diagnosed bearing 14 is mounted. Thanks to suitable design of the links of the segment strip 8 the strip can be well matched in a rigid manner to the pitch diameter D of the diagnosed bearing, wherein the movable crossbar 11 is stably mounted on the guiding element 1 by means of a screw 12. The elements of the movable links are made of a non-magnetic material (e.g., plastic or stainless steel) and can be shaped like a bicycle chain with riveted connections one to each other at the ends of the riveted elements forming the links, with possibility of their mutual displacement. On the riveted elements, preferably, on every second element, sensors 9 are fixed, preferably by gluing connection.

## Claims

1. A diagnostic system for diagnosing of rolling bearings during their operation, directly at the place where they are installed in a tested structure, comprising an assembly of sensors arranged in the immediate vicinity of a bearing to be diagnosed and along a perimeter of its side surface, preferably, directly at the height of rolling elements of the bearing, especially, preferably, at a pitch diameter, and a support element on which the sensors included in the sensor assembly are mounted, which sensors are further connected by means of signal transmission connection to a recording unit in the form of a recorder, which recorder is connected to an analysis block, **characterized in that** the sensor assembly includes at least three sensors which are magneto-impedance sensors (A, B, C; 4, 9) of magnetic field, that are arranged at well-defined locations along a perimeter of the side surface of the diagnosed bearing, wherein at least two sensors (4; A and B) are located at locations lying in the load plane (P) of the bearing, one opposite to each other along a diameter, and wherein at least one sensor (4; C) is located at the side surface of the bearing, in the plane perpendicular to the load plane (P), at a location in angular distance of 90 degrees along the perimeter of the bearing away from the load plane (P), and wherein the support element is equipped with an adjustment system in which magneto-impedance sensors (4, 9; A, B and C) are mounted, with possibility of adjustment of their position relative to the diagnosed bearing, in both horizontal and vertical directions, and further wherein the support element is fixedly mounted on structural element (10) of the tested structure.

2. The diagnostic system for diagnosing of rolling bearings according to claim 1, **characterized in that** all magneto-impedance sensors (4, 9; A, B and C) of magnetic field are located in one common plane.

3. The diagnostic system for diagnosing of rolling bearings according to one of claims 1 - 2, **characterized in that** the support element has an adjustment system containing a stable mounted guiding element (1), designed to be fixed on the structural element (10) of the tested structure, wherein crossbars (3) are installed movably in at least two planes on the guiding element (1), for adjusting the position of magneto-impedance sensors (4; A, B, C), that are mounted on said crossbars (3), to the diameter of the diagnosed bearing (14), preferably, maintaining at the same time a constant distance from the front plane of the diagnosed bearing (14) by means of spacers (13) that are provided.

4. The diagnostic system for diagnosing of rolling bearings according to one of claims 1 - 3, **characterized in that** there are sliding elements (2) mounted slideably in vertical direction on the guiding element (1), in which sliding elements (2) the crossbars (3) are seated movably in horizontal direction, on which crossbars individual magneto-impedance sensors (4; A, B, C) are mounted, wherein at least one sensor (4; A, B, C) is mounted on each crossbar (3), preferably exactly one sensor.

5. A diagnostic system for diagnosing of rolling bearings according to one of the claims 1 - 2, **characterized in that** the magneto-impedance sensors (9) are arranged and mounted on a flexible segment measuring strip (8), which is arranged around a circumference of the diagnosed bearing, along its side surface, at the height of rolling elements (7) and along these rolling elements, and which measuring strip is mounted fixedly on a support element equipped with an adjustment system, that contains the guiding element (1).

6. The diagnostic system for diagnosing of rolling bearings according to one of preceding claims 1 - 2 or 5, **characterized in that,** the segment measuring strip (8) together with magneto-impedance sensors (9) mounted on it, along its length, is constructed of movably connected, one to each other, segment elements (8) in the form of links and has an overall length L, wherein the segment elements can be adjusted to the diameter of the bearing (14) at the height of its rolling elements (7), and further wherein magneto-impedance sensors (9) are designated to record the magnetic field distribution along the rolling elements (7), while the segment measuring strip (8) is attached to a movable crossbar (11), that is mounted on the guiding element (1), which guiding element (1) is fixedly mounted on the structural element (10) of the tested structure.

7. The diagnostic system for diagnosing of rolling bearings according to one of preceding claims 1-6, **characterized in that,** a signal from each of the magneto-impedance sensors (4, 9; A, B, C), each of which measures the magnetic field generated by the rotating bearing, which signal is, preferably, magnetic field distribution signal, is transmitted to the recorder (5) and, further, after the signal is recorded in the recorder (5) it is transmitted to the analysis block (6) and it is analyzed in this block by comparing the signal signatures from each of the individual magneto-impedance sensors (4, 9; A, B and C).
